# FASCICULE DE BREVET EUROPEEN

(11) **EP 4 001 458 B1**
(45) Date de publication et mention de la délivrance du brevet: **16.10.2024**
(21) Numéro de dépôt: 20208090.9
(22) Date de dépôt: 17.11.2020
(51) Int. Cl.: C23C 14/00, G04B 19/12, C23C 16/00, G04B 5/16, G04B 13/02, G04B 19/04, G04B 19/28, G04B 45/00, G04B 29/02, G04B 37/22, C23C 16/455

(54) **PROCEDE DE DEPOT D'UN REVETEMENT SUR UN COMPOSANT HORLOGER ET COMPOSANT HORLOGER REVETU PAR UN TEL PROCEDE**
VERFAHREN ZUM AUFBRINGEN EINER BESCHICHTUNG AUF EIN UHRWERKBAUTEIL UND NACH DIESEM VERFAHREN BESCHICHTETES UHRWERKBAUTEIL
METHOD FOR DEPOSITING A COATING ON A TIMEPIECE COMPONENT AND TIMEPIECE COMPONENT COATED BY SUCH A METHOD

(43) Date de publication de la demande: 25.05.2022
(73) Titulaire: The Swatch Group Research and Development Ltd, 2074 Marin (CH)
(72) Inventeur: MANASTERSKI, Christian, 2019 Rochefort (CH); FAURE, Cédric, 2016 Cortaillod (CH); SPASSOV, Vladislav, 1788 Praz (CH)
(74) Mandataire: ICB SA

(56) Documents cités:
- CH-A2- 715 364
- CN-A- 103 852 815
- US-A1- 2008 160 193

## Description

### Domaine technique de l'invention

Le domaine de l'invention concerne les traitements de surface d'articles tels que des articles de décoratif ou des composants horlogers, et en particulier les revêtements décoratifs et/ou protecteurs d'articles.

L'invention concerne plus particulièrement un procédé de dépôt d'un revêtement décoratif et/ou protecteur permettant d'obtenir un revêtement coloré présentant un effet interférentiel.

Le procédé de dépôt d'un revêtement selon l'invention est particulièrement adapté à la protection et/ou à la décoration d'articles décoratifs ou de composants utilisés dans les pièces d'horlogerie, comme par exemple les platines, les ponts, les rouages, les vis, les masses oscillantes, les cadrans, les index, les appliques, les guichets, les aiguilles ou encore tout autre composant du mouvement ou de l'habillage externe d'une pièce horlogerie.

L'invention concerne également un composant horloger revêtu par un tel procédé.

### Arrière-plan technologique

Pour obtenir des couches protectrices et/ou décoratives sur différents substrats, il est connu d'utiliser des techniques de dépôt physique en phase vapeur (PVD pour Physical Vapor Déposition en langue anglaise).

Ces méthodes PVD sont utilisées par exemple pour donner un aspect esthétique distinctif à des éléments apparents utilisés dans la production de produits d'horlogerie.

Par exemple, il est connu d'appliquer des revêtements par une méthode PVD sur des pièces métalliques leur conférant un aspect brillant ou mât selon l'état de la surface initiale, gris métallique, noir ou encore coloré selon le procédé utilisé. Toutefois la palette de couleurs que l'on peut obtenir par ces techniques reste limitée.

Par ailleurs, il est également connu de déposer par des procédés PVD des couches minces et transparentes avec une épaisseur comparable ou inférieure aux longueurs d'onde de la lumière visible, qui donnent aux surfaces sur lesquelles elles sont déposées une couleur attribuable à un phénomène d'interférence, on parle alors de couleur interférentielle.

Un tel procédé permet d'obtenir différentes couleurs interférentielles allant du jaune foncé au vert, en passant par des tonalités de violet et de bleu. Cependant, comme vu précédemment, la palette de couleurs reste limitée et lorsque les pièces à revêtir ne sont pas planes, mais de géométrie complexe, la couleur obtenue n'est pas uniforme, ce qui n'est esthétiquement pas satisfaisant car le rendu est peu qualitatif.

On connaît également la technologie ALD (pour Atomic Layer Déposition en langue anglaise) qui est une forme de dépôt chimique en phase vapeur (CVD). Cette technologie ALD est utilisée en horlogerie pour la décoration et la protection contre la corrosion des pièces d'horlogerie.

Le document « Atomic Layer Déposition (ALD) : une technologie prometteuse pour l'industrie horlogère », bulletin SSC n°81, mai 2016, décrit notamment la possibilité d'utiliser la technologie ALD, en remplacement de la technologie PVD, pour la protection contre la corrosion et pour déposer des revêtements de couleur interférentielle formés par une unique couche mince transparente déposée directement sur un substrat réfléchissant.

En comparaison avec la technologie PVD, la technologie ALD permet d'obtenir des couches parfaitement uniformes assurant une homogénéité de l'épaisseur sur toute la périphérie de la pièce, conférant ainsi une couleur uniforme à la surface de pièces à géométrie complexe. La technologie ALD permet également une mise en couleur sous forme de couleurs interférentielles et les propriétés des revêtements obtenus par ALD conviennent particulièrement à la protection des pièces à géométrie complexe.

Toutefois, la technologie ALD telle que décrite ne permet pas d'étendre davantage la palette de couleurs interférentielles qu'il est possible d'obtenir.

Le document CH 709 669 propose de réaliser un revêtement pour la protection et/ou la décoration d'un composant de pièce d'horlogerie comprenant une première couche métallique déposée par une méthode PVD et une deuxième couche semi-transparente déposée par une méthode ALD au-dessus de la première couche, la deuxième couche semi-transparente présentant une épaisseur importante permettant d'obtenir des couleurs interférentielles dans la gamme des brun, magenta, bleu, jaune, orange, violet, vert, rose, selon l'épaisseur croissante de la couche ALD semi-transparente.

Le document CH 709 669 propose une solution permettant d'élargir légèrement la palette de couleurs interférentielles par rapport aux documents de l'état de la technique en proposant pour une même tonalité interférentielle, la possibilité d'obtenir une nuance plus foncée ou plus claire, et donc de faire varier la clarté (i.e. le paramètre L* de l'espace chromatique L*a*b), en fonction de l'utilisation d'une couche PVD métallique grise ou brillante sous la couche ALD. Le document CH 715 364 A2 propose un procédé pour améliorer l'adhérence d'une couche de protection contre le ternissement de l'argent sur un substrat comprenant une surface argentée. Le document EP 3 896 192 A1 montre un composant horloger avec un système optique amélioré.

Toutefois, les procédés de revêtement actuels ne permettent pas d'obtenir une palette étendue de couleurs interférentielles, ce qui limite les possibilités de décor des composants horlogers avec des phénomènes interférentiels.

### Résumé de l'invention

Dans ce contexte, l'invention vise à proposer un procédé de dépôt d'un revêtement décoratif et/ou protecteur sur un substrat exempt des limitations des procédés de revêtements connus et décrits précédemment.

Selon l'invention, un des buts de l'invention est de proposer un procédé de dépôt d'un revêtement décoratif et/ou protecteur permettant d'obtenir une large gamme de couleurs interférentielles dans une même tonalité avec des variations de teintes proches, et notamment une large gamme de couleurs interférentielles dans la tonalité des bleus.

A cet effet, l'invention a pour objet un procédé de dépôt d'un revêtement décoratif et/ou protecteur sur un substrat pour la formation d'un composant horloger permettant de colorer ledit substrat, ledit procédé de dépôt étant caractérisé en ce qu'il comporte :
- une première étape de dépôt d'une première couche opaque sur le substrat ;
- une deuxième étape de dépôt par une méthode ALD (dépôt par couches atomiques) d'un empilement d'au moins deux couches semi-transparentes recouvrant ladite première couche ; l'épaisseur de l'empilement étant choisie de manière à obtenir une couleur avec un phénomène d'interférence.

La formation d'une couleur interférentielle, ou d'une couleur présentant un phénomène d'interférence, est due au décalage entre la lumière réfléchie par la première couche opaque recouvrant au moins partiellement une surface du substrat ; et celle réfléchie par l'empilement de couches semi-transparentes déposées par une méthode ALD, recouvrant la couche opaque.

Ainsi contrairement aux documents de l'état de la technique précédemment cités dans lesquels la couleur du revêtement final est dépendant du matériau déposé par une méthode PVD sur le composant horloger, la couche PVD pouvant être parfois revêtue par une couche transparente déposée par une méthode ALD dans un unique but de protection de la couche PVD, le procédé selon l'invention va à l'encontre des préjugés de l'état de la technique puisque la couleur finale du revêtement est déterminée par la combinaison de la couche opaque (préférentiellement déposé par une méthode PVD) et de l'empilement de couches ALD qui ne sont pas transparentes mais au contraire semi-transparente dans le but de modifier les paramètres L*a*b* de la couche opaque.

Préférentiellement, la première étape est une étape de dépôt d'une première couche métallique ou céramique sur ledit substrat.

Préférentiellement, ladite première couche est une couche de TiN, TiCN, TiCNO, TiC, ZrN, ZrCN, ZrCNO, ZrC, HfN, HfCN, HfCNO, HfC, YN, YC, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN, ou MoCNO.

Préférentiellement, la nature chimique de ladite première couche est choisie en fonction du paramètre L* selon le standard CIELAB de ladite couleur avec un phénomène d'interférence dudit revêtement.

Préférentiellement, la première étape est réalisée par un procédé PVD (Dépôt Physique en Phase Vapeur).

Préférentiellement, la première couche présente une épaisseur (e₁) supérieure à 450 nm, préférentiellement comprise entre 500 nm et 1 µm.

Préférentiellement, lesdites au moins deux couches semi-transparentes de l'empilement sont de natures chimiques différentes et/ou présentent un indice de réfraction différent.

Préférentiellement, les épaisseurs de chacune desdites au moins deux couches semi-transparentes de l'empilement sont choisies en fonction des paramètres a* et b*, selon le standard CIELAB, de ladite couleur avec un phénomène d'interférence du revêtement.

Préférentiellement, lesdites au moins deux couches semi-transparentes de l'empilement déposées lors de la deuxième étape sont des couches d'un matériau choisi parmi les matériaux diélectriques, semi-conducteurs, métalliques, ou encore céramiques.

Préférentiellement, lesdites au moins deux couches semi-transparentes de l'empilement déposées lors de la deuxième étape sont des couches d'un matériau choisi parmi : Al₂O₃, TiO2, SiO₂, Ta₂O₅, HfO₂, ZrO₂, ZnO, SnO, Al, Ru, Ir, Pt, TiN, TaN, Si₃N₄, WN, NbN.

Préférentiellement, une première couche semi-transparente desdites au moins deux couches semi-transparentes de l'empilement présente un indice de réfraction inférieur à 2, préférentiellement inférieur à 1,6, et une deuxième couche semi-transparente desdites au moins deux couches semi-transparentes de l'empilement présente un indice de réfraction supérieur à 2, préférentiellement supérieur à 2,5.

L'invention a également pour objet un composant horloger comportant un substrat et un revêtement présentant une couleur avec un effet interférentiel pour la décoration et/ou la protection dudit article, ledit revêtement comportant :
- une première couche opaque recouvrant au moins partiellement au moins une surface du substrat ;
- un empilement d'au moins deux couches semi-transparentes déposée par un procédé ALD (Dépôt par Couches Atomiques) recouvrant ladite première couche ; l'empilement présentent une épaisseur fonction de ladite couleur avec un phénomène d'interférence dudit revêtement.

Préférentiellement, la première couche est une couche métallique ou une couche céramique.

Préférentiellement, la première couche est une couche de TiN, TiCN, TiCNO, TiC, ZrN, ZrCN, ZrCNO, ZrC, HfN, HfCN, HfCNO, HfC, YN, YC, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN, ou MoCNO.

Préférentiellement, la nature chimique de ladite première couche (11) est fonction du paramètre L* selon le standard CIELAB de ladite couleur avec un phénomène d'interférence dudit revêtement.

Préférentiellement, la première couche est déposée par un procédé PVD (Dépôt Physique en Phase Vapeur).

Préférentiellement, la première couche présente une épaisseur e₁ supérieure à 450nm, préférentiellement comprise entre 500 nm et 1 µm.

Préférentiellement, lesdites au moins deux couches semi-transparentes de l'empilement sont de natures chimiques différentes et/ou présentent un indice de réfraction différent.

Préférentiellement, les épaisseurs de chacune desdites au moins deux couches semi-transparentes de l'empilement sont fonction des paramètres a* et b*, selon le standard CIELAB, de ladite couleur avec un phénomène d'interférence du revêtement.

Préférentiellement, lesdites au moins deux couches semi-transparentes de l'empilement sont des couches d'un matériau choisi parmi les matériaux diélectriques, semi-conducteurs, métalliques, ou encore céramiques.

Préférentiellement, lesdites au moins deux couches semi-transparentes de l'empilement sont des couches d'un matériau choisi parmi : Al₂O₃, TiO₂, SiO₂, Ta₂O₅, HfO₂, ZrO₂, ZnO, SnO, Al, Ru, Ir, Pt, TiN, TaN, Si₃N₄, WN, NbN.

Préférentiellement, une première couche semi-transparente desdites au moins deux couches semi-transparentes de l'empilement présente un indice de réfraction inférieur à 2, préférentiellement inférieur à 1,6, et une deuxième couche semi-transparente desdites au moins deux couches semi-transparentes de l'empilement présente un indice de réfraction supérieur à 2, préférentiellement supérieur à 2,5.

L'invention a également pour objet une pièce d'horlogerie comportant un composant horloger.

### Brève description des figures

Les buts, avantages et caractéristiques de la présente invention apparaîtront à la lecture de la description détaillée ci-dessous faisant référence aux figures suivantes :
- la figure 1 illustre schématiquement un exemple de structure multicouche d'un revêtement décoratif et/ou protecteur selon l'invention déposé sur un substrat formant un article, tel qu'un composant horloger ;
- la figure 2 illustre les principales étapes successives d'un exemple de réalisation du procédé de dépôt d'un revêtement décoratif et/ou protecteur sur un substrat pour la réalisation d'un article, tel qu'un composant horloger, selon l'invention ;
- la figure 3 illustre un exemple de réalisation d'un article selon l'invention.

### Description détaillée de l'invention

Dans la présente description, les propriétés colorimétriques du revêtement obtenu selon le procédé de dépôt d'un revêtement selon l'invention sont exprimées à l'aide de l'espace colorimétrique CIE L*a*b* et mesurées selon le standard CIE 1976 sur des échantillons polis avec un spectrophotomètre KONICA MINOLTA CM-3610-A, avec les paramètres suivants : source d'éclairage CIE D65 (lumière du jour 6500°K), inclinaison de 10°, mesures SCI (réflexion spéculaire incluse), zone de mesure de 4 mm de diamètre.

Un espace colorimétrique CIELAB (conforme aux normes CIE n°15, ISO 7724/1, DIN 5033 Teil 7, ASTM E-1164) présente une composante de luminance L*, représentative de la manière dont le matériau réfléchit la lumière, assimilable à la clarté, avec une composante a* qui est la composante vert/rouge et une composante b* qui est la composante bleu/jaune.

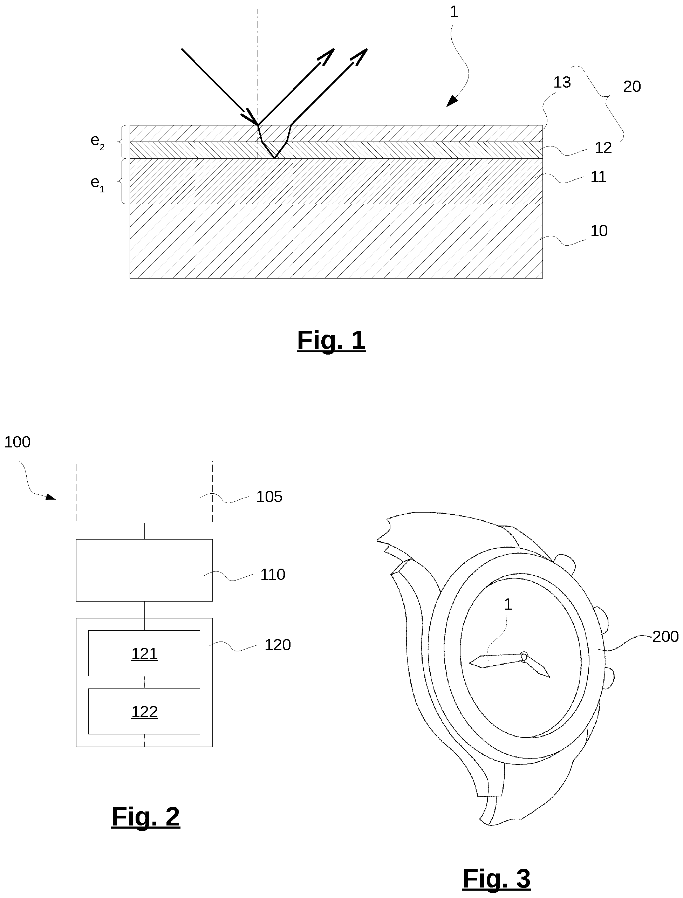

La figure 1 illustre schématiquement une vue en coupe d'un article 1, tel qu'un composant horloger, comportant un substrat 10 ainsi qu'une structure multicouche d'un revêtement décoratif et/ou protecteur déposé sur un substrat au moyen du procédé de dépôt d'un revêtement selon l'invention.

L'article 1 est par exemple un composant horloger, par exemple une platine, un pont, une roue, une vis, une masse oscillante, un cadran, un index, une applique, un guichet, une aiguille ou encore tout autre composant ou organe d'un mouvement d'horlogerie ou d'un composant d'habillage d'une pièce d'horlogerie auquel on souhaite donner une couleur, et notamment une couleur interférentielle.

La figure 3 illustre une pièce d'horlogerie 200 comportant un article 1 selon l'invention. Dans ce mode de réalisation, l'article 1 selon l'invention est une aiguille.

Le substrat 10 peut être de nature variable, par exemple en matière métallique, en matière plastique ou encore en matière céramique, voire en matière composite, et peut présenter une couleur variable. Grâce au procédé selon l'invention, il est possible d'obtenir une même couleur interférentielle L*a*b* finale avec des substrats de nature et/ou de couleur différentes.

Le substrat 10 présente au moins une surface recouverte au moins partiellement par une première couche 11 déposée par un procédé de dépôt physique en phase vapeur ou PVD (pour Physical Vapor Déposition), qui est elle-même recouverte par un empilement 20 d'au moins deux couches semi-transparente 12, 13 déposées par un procédé ALD de manière à former une structure multicouche.

La première couche 11 PVD et les deux couches semi-transparente 12, 13 ALD peuvent également recouvrir intégralement le substrat 10, i.e. l'ensemble des faces du substrat 10, ou uniquement les faces visibles du substrat 10.

La première couche 11 présente une couleur intrinsèque et présente une épaisseur e₁ suffisante pour que celle-ci soit opaque et que la perturbation optique du substrat 10 ne soit plus active.

Préférentiellement, la première couche 11 présente une épaisseur e₁ égale ou supérieure à 450 nm, et plus préférentiellement une épaisseur e₁ comprise entre 500 nm et 1 µm. Ainsi, on s'assure que la couleur du substrat 10 ne viendra pas perturber optiquement la couleur L*a*b* du revêtement final.

La première couche 11 peut être une couche métallique ou une couche céramique.

Préférentiellement, la première couche 11 est une couche à base de matériau céramique. L'utilisation d'une première couche 11 à base de matériau céramique permet avantageusement de pouvoir étendre la palette de couleurs possibles au niveau de la première couche 11, en comparaison avec une première couche à base de matériau métallique, dont les tonalités sont limitées au jaune, au gris, au blanc. Ainsi, en élargissant la palette de couleurs de la première couche 11, il est possible d'augmenter la palette de couleurs interférentielles du revêtement final en influant sur la clarté/brillance de la couleur interférentielle (i.e. en influant sur le paramètre L*).

A titre d'exemple, la première couche 11 est une couche à base d'un matériau céramique sélectionné parmi le groupe consistant en TiN, TiCN, TiCNO, TiC, ZrN, ZrCN, ZrCNO, ZrC, HfN, HfCN, HfCNO, HfC, YN, YC, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN, ou MoCNO.

Ainsi, grâce à l'utilisation de tels matériaux céramiques, il est possible d'obtenir une première couche 11 déposée par un procédé PVD, avec une tonalité rouge, orange, jaune, verte, bleue, violette, rose, brune, noire, blanche ou encore grise.

Avantageusement, le matériau de la première couche 11 sera choisi de manière à avoir une première couche 11 avec des coordonnées a* et b* proches de zéro, de sorte que la première couche 11 présente une tonalité neutre sans tendance verte, rouge, bleue ou encore jaune.

La première couche 11 est recouverte par un empilement 20 d'une pluralité de couches semi-transparentes 12, 13 déposées par un procédé de dépôt de couches atomiques ou ALD (pour Atomic Layer Déposition). Dans l'exemple de réalisation représenté à la figure 1, l'empilement 20 comporte deux couches semi-transparentes 12 et 13 formant ainsi une deuxième couche 12 et une troisième couche 13 de la structure multicouche du revêtement selon l'invention.

Bien entendu, l'empilement 20 déposé par ALD peut être constitué par plus que deux couches semi-transparentes.

Les différentes couches semi-transparentes de l'empilement 20 sont avantageusement de natures chimiques différentes. En l'espèce, le deuxième couche 12 et la troisième couche 13 sont de natures chimiques différentes.

Lorsque que l'empilement 20 comporte au moins trois couches semi-transparentes, au moins deux couches de l'empilement sont de natures chimiques différentes. Avantageusement les deux couches de natures chimiques différentes sont déposées successivement.

Préférentiellement, les différentes couches semi-transparentes de l'empilement présentent un indice de réfraction n différent. En l'espèce, la deuxième couche 12 et la troisième couche 13 déposées par un procédé ALD présentent un indice de réfraction n différent.

Lorsque que l'empilement 20 comporte au moins trois couches semi-transparentes, au moins deux couches de l'empilement présentent un indice de réfraction n différent. Avantageusement les deux couches présentant un indice de réfraction n différent sont déposées successivement.

Préférentiellement, une des couches de l'empilement 20 déposé par ALD, par exemple la deuxième couche 12, est une couche à bas indice de réfraction (i.e. inférieur à 2, et préférentiellement inférieur à 1,6) tandis que l'autre couche de l'empilement ALD, par exemple la troisième couche 13, est une couche à haut indice de réfraction (i.e. supérieur à 2, et préférentiellement supérieur à 2,5). Bien entendu, l'inverse est également envisagé.

Les couches semi-transparentes 12 et 13 de l'empilement 20 peuvent être des couches à base de matériau diélectrique, semi-conducteur, métallique, ou encore céramique.

Chacune des couches semi-transparentes 12, 13 de l'empilement 20 déposées par un procédé ALD peut être par exemple un oxyde d'aluminium Al₂O₃, un oxyde de titane TiO₂, un oxyde de silicium SiO₂, un oxyde de tantale Ta₂O₅, un oxyde d'hafnium HfO₂, un oxyde de zirconium ZrO₂, un oxyde de zinc ZnO, ou encore un oxyde d'étain SnO.

Chacune des couches semi-transparentes 12, 13 peut également être une couche très fine de métal (AI, Ru, Ir, Pt), de matière céramique à base de nitrure (Si3N4, WN, NbN, TiN, TaN) ou encore de carbure, telle que mentionnée précédemment en référence à la première sous-couche 11.

L'épaisseur e₂ de l'empilement 20 est choisie en fonction de la couleur interférentielle que l'on souhaite obtenir et de sorte que l'épaisseur e₂ soit comparable ou inférieure à la longueur d'onde de la couleur désirée.

De manière classique, pour obtenir une couleur interférentielle, l'épaisseur e₂ de l'empilement ALD est préférentiellement comprise entre 50 nm à 200 nm.

La figure 2 illustre les principales étapes du procédé de dépôt 100 d'un revêtement sur un substrat 10 selon l'invention. Ainsi, le procédé de dépôt 100 selon l'invention comporte une première étape 110 de dépôt d'une première couche 11 réalisée par un procédé de dépôt physique en phase vapeur (PVD pour Physical Vapor Déposition).

Par exemple, la première étape 110 de dépôt d'une première couche 11 est réalisée par un procédé par pulvérisation cathodique (sputtering). Le gaz de pulvérisation est inerte, typiquement de l'argon. Les paramètres de dépôt PVD sont déterminés par l'homme du métier de manière à obtenir une opacité de la première couche 11 satisfaisante et de manière à ce que la perturbation optique du substrat 10 ne soit plus active.

Le procédé de dépôt d'un revêtement 100 selon l'invention comporte en outre une deuxième étape 120 de dépôt réalisée par un procédé de dépôt de couches atomiques ou ALD (pour Atomic Layer Déposition), la deuxième étape intervenant après la première étape 110 de sorte que les différentes couches atomiques sont déposées par empilement successif sur la première couche 11 PVD.

Le procédé ALD est un procédé de dépôt de couches minces atomiques qui fait partie des dépôts chimiques en phase vapeur, ou CVD (pour Chemical Vapor Déposition). Il permet à partir d'un précurseur gazeux, de déposer des couches monoatomiques qui sont individuellement oxydées pour obtenir une couche continue d'oxyde.

A titre d'exemple, il est connu d'utiliser le précurseur triméthylaluminium (TMA, Al(CH₃)₃) pour obtenir des couches d'Al₂O₃, et le précurseur tétrakis diméthylamide de titane (TDMAT, C₈H₂₄N₄Ti) pour obtenir des couches de TiO₂.

La deuxième étape 120 de dépôt ALD comporte une première sous-étape 121 de dépôt par un procédé ALD de la deuxième couche 12 décrite précédemment et une deuxième sous-étape 122 de dépôt par un procédé ALD de la troisième couche 13 décrite précédemment, la deuxième couche 12 et la troisième couche 13 étant de natures chimiques différentes et présentant des indices de réfraction n différents.

Bien entendu, cette deuxième étape 120 du procédé de dépôt 100 selon l'invention peut comporter autant de sous-étapes de dépôt de couche par un procédé ALD que l'empilement 20 comporte de couches semi-transparentes.

En complément, l'utilisation d'un empilement 20 de couches semi-transparentes 12, 13 de compositions différentes, déposées successivement par un procédé ALD, permet de pouvoir combiner plusieurs indices de réfraction à l'intérieur de l'empilement ALD. Une telle combinaison permet avantageusement de pouvoir faire varier les paramètres a* et b* de l'espace colorimétrique L*a*b*, et donc la teinte de la couleur interférentielle finale sans toutefois modifier sa tonalité. Ainsi, le procédé selon l'invention permet d'obtenir, par exemple, différentes teintes de bleu avec un phénomène d'interférence en faisant varier les épaisseurs des couches ALD ainsi que la nature chimique des couches ALD.

Ainsi, grâce au procédé de dépôt 100 d'un revêtement selon l'invention, il est possible d'interagir sur l'espace colorimétrique L*a*b* de la couleur tout en gardant le phénomène d'interférence recherché, en faisant varier les paramètres suivants :
- indices de réfraction n des couches semi-transparentes déposées par ALD, typiquement de la deuxième couche 12 et de la troisième couche 13 dans l'exemple de réalisation illustré à la figure 1 ;
- coefficient d'extinction k des couches semi-transparentes ALD ;
- épaisseurs des couches semi-transparentes à l'intérieur de l'empilement 20 déposées par ALD ;
- indice de réfraction n, coefficient d'extinction k et coordonnées L*a*b* de la première couche 11 appliquée par PVD servant de support aux couches semi-transparentes ALD, par modification de la composition de la première couche 11 PVD.

Selon un premier exemple de réalisation, pour obtenir un revêtement avec une couleur bleue interférentielle ayant comme paramètre de couleur L* = 37,6 ± 1,5, paramètre de couleur a* = - 7,5 ± 0,8, et paramètre de couleur b* = - 22,3 ± 0,8, le procédé selon l'invention consiste à déposer une première couche de CrC de 500 nm d'épaisseur par une méthode PVD, à déposer une deuxième couche de TiO₂ de 34,8 nm d'épaisseur par une méthode ALD sur la première couche PVD, suivi d'une troisième couche d'Al₂O₃ de 39,3 nm d'épaisseur par une méthode ALD.

Selon un deuxième exemple de réalisation, pour obtenir un revêtement avec une couleur bleue interférentielle ayant comme paramètre de couleur L* = 31,6 ± 1,5, paramètre de couleur a* = - 7,1 ± 0,8, et paramètre de couleur b* = - 22,8 ± 0,8, le procédé selon l'invention consiste à déposer une première couche de CrC de 500 nm d'épaisseur par une méthode PVD, à déposer une deuxième couche de TiO₂ de 41,0 nm d'épaisseur par une méthode ALD sur la première couche PVD, suivi d'une troisième couche d'Al₂O₃ de 25,0 nm d'épaisseur par une méthode ALD.

Selon un troisième exemple de réalisation, pour obtenir un revêtement avec une couleur bleue interférentielle ayant comme paramètre de couleur L* = 32,6 ± 1,5, paramètre de couleur a* = - 5,7 ± 0,8, et paramètre de couleur b* = - 27 ± 0,8, le procédé selon l'invention consiste à déposer une première couche de CrC de 500 nm d'épaisseur par une méthode PVD, à déposer une deuxième couche d'Al₂O₃ de 10 nm d'épaisseur par une méthode ALD, suivi d'une troisième couche de TiO₂ de 55 nm d'épaisseur par une méthode ALD.

Bien entendu, d'autres combinaisons de matériaux (autre que Al₂O₃/TiO₂) peuvent être envisagées pour obtenir différentes teintes de couleurs interférentielles.

On peut ainsi utiliser et combiner différents oxydes parmi Al₂O₃, TiO₂, SiO₂, Ta₂O₅, HfO₂, ZrO₂, ZnO, SnO.

L'empilement 20 peut également présenter trois, quatre ou encore cinq couches semi-transparentes avec des indices de réfraction différents de manière à augmenter davantage la palette de teintes possibles pour une même tonalité de couleur interférentielle. On veillera toutefois que l'épaisseur total de l'empilement 20 ne présente pas une épaisseur supérieure à 200nm de manière à obtenir une couleur avec un effet d'interférence.

Les différentes couches du revêtement selon l'invention, et plus particulièrement la première couche PVD 11 et l'empilement 20 de couches ALD, typiquement la deuxième couche 12 et la troisième couche 13, peuvent être déposées dans deux réacteurs séparés, ou dans un seul et unique réacteur sans sortir du cadre de l'invention.

Préalablement aux étapes de dépôt 110, 120 décrites précédemment, le procédé 100 selon l'invention peut également comporter de manière optionnelle, une étape de préparation 105 du substrat 10.

Cette étape de préparation 105 peut comporter une étape de nettoyage du substrat 10. De manière connue de l'homme du métier, cette étape de nettoyage peut être réalisée par exemple par dégraissage chimique, suivi d'un rinçage à l'eau de ville et à l'eau déminéralisée. Le substrat 10 est ensuite séché et est prêt pour la mise en oeuvre des étapes de dépôt 110, 120 mentionnées précédemment.

Cette étape de préparation 105 peut également comporter une étape d'activation ionique. Les paramètres de l'activation ionique sont déterminés par l'homme du métier. L'activation ionique garantit la parfaite adhérence de la première couche 11 PVD déposée directement sur les surfaces nues du substrat 10.

Le procédé de dépôt d'un revêtement décoratif et/ou protecteur selon l'invention présente de nombreux avantages :
- il permet de maitriser la colorimétrie interférentielle obtenue indépendamment de la nature du substrat et de la couleur initiale du composant horloger ;
- le dépôt du revêtement est effectué à basse température ce que permet de ne pas influencer la structure cristalline du composant horloger ; par conséquent, le procédé de dépôt d'un revêtement selon l'invention est applicable à une grande variété de composants horlogers ;
- il permet de régler avec une grande simplicité et une bonne reproductibilité les différentes épaisseurs des couches déposées à la valeur désirée pour obtenir la couleur L*a*b* interférentielle désirée ;
- l'épaisseur de chaque couche ALD, et donc la couleur interférentielle finale du composant d'horlogerie ainsi revêtu, est régulière et répétable.

## Revendications

1. Procédé de dépôt (100) d'un revêtement décoratif et/ou protecteur sur un substrat (10) pour la formation d'un composant horloger (1), permettant de colorer ledit substrat (10), ledit procédé de dépôt (100) comportant
- une première étape (110) de dépôt d'une première couche (11) opaque sur le substrat (10) ; ledit procédé étant **caractérisé en ce qu'**il comporte :
- une deuxième étape (120) de dépôt par une méthode ALD (dépôt par couches atomiques) d'un empilement (20) d'au moins deux couches semi-transparentes (12, 13) recouvrant ladite première couche (11) ; l'épaisseur (e2) de l'empilement (20) étant choisie de manière à obtenir une couleur avec un phénomène d'interférence.

2. Procédé de dépôt (100) d'un revêtement décoratif et/ou protecteur sur un substrat (10) pour la formation d'un composant horloger (1), selon la revendication précédente **caractérisé en ce que** la première étape (110) est une étape de dépôt d'une première couche (11) métallique ou céramique sur ledit substrat (10).

3. Procédé de dépôt (100) d'un revêtement décoratif et/ou protecteur sur un substrat (10) pour la formation d'un composant horloger (1), selon la revendication précédente **caractérisé en ce que** ladite première couche (11) est une couche de TiN, TiCN, TiCNO, TiC, ZrN, ZrCN, ZrCNO, ZrC, HfN, HfCN, HfCNO, HfC, YN, YC, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN, ou MoCNO.

4. Procédé de dépôt (100) d'un revêtement décoratif et/ou protecteur sur un substrat (10) pour la formation d'un composant horloger (1), selon la revendication précédente **caractérisé en ce que** la nature chimique de ladite première couche (11) est choisie en fonction du paramètre L* selon le standard CIELAB conforme aux normes CIE n°15, ISO 7724/1, DIN 5033 Teil 7, ASTM E-1164, de ladite couleur avec un phénomène d'interférence dudit revêtement.

5. Procédé de dépôt (100) d'un revêtement décoratif et/ou protecteur sur un substrat (10) pour la formation d'un composant horloger (1), selon l'une des revendications précédentes, **caractérisé en ce que** la première étape (110) est réalisée par un procédé PVD (dépôt physique en phase vapeur).

6. Procédé de dépôt (100) d'un revêtement décoratif et/ou protecteur sur un substrat (10) pour la formation d'un composant horloger (1), selon l'une des revendications précédentes, **caractérisé en ce que** la première couche (11) déposée lors de la première étape (110) présente une épaisseur (e₁) supérieure à 450 nm, préférentiellement comprise entre 500 nm et 1 µm.

7. Procédé de dépôt (100) d'un revêtement décoratif et/ou protecteur sur un substrat (10) pour la formation d'un composant horloger (1), selon l'une des revendications précédentes, **caractérisé en ce que** lesdites au moins deux couches semi-transparentes (12, 13) de l'empilement (20) sont de natures chimiques différentes et/ou présentent un indice de réfraction différent.

8. Procédé de dépôt (100) d'un revêtement décoratif et/ou protecteur sur un substrat (10) pour la formation d'un composant horloger (1), selon l'une des revendications précédentes, **caractérisé en ce que** les épaisseurs de chacune desdites au moins deux couches semi-transparentes (12, 13) de l'empilement (20) sont choisies en fonction des paramètres a* et b*, selon le standard CIELAB, conforme aux normes CIE n°15, ISO 7724/1, DIN 5033 Teil 7, ASTM E-1164, de ladite couleur avec un phénomène d'interférence du revêtement.

9. Procédé de dépôt (100) d'un revêtement décoratif et/ou protecteur sur un substrat (10) pour la formation d'un composant horloger (1), selon l'une des revendications précédentes, **caractérisé en ce que** lesdites au moins deux couches semi-transparentes (12, 13) de l'empilement (20) déposées lors de la deuxième étape (120) sont des couches d'un matériau choisi parmi les matériaux diélectriques, semi-conducteurs, métalliques, ou encore céramiques.

10. Procédé de dépôt (100) d'un revêtement décoratif et/ou protecteur sur un substrat (10) pour la formation d'un composant horloger (1), selon l'une des revendications précédentes, **caractérisé en ce que** lesdites au moins deux couches semi-transparentes (12, 13) de l'empilement (20) déposées lors de la deuxième étape (120) sont des couches d'un matériau choisi parmi : Al₂O₃, TiO₂, SiO₂, Ta₂O₅, HfO₂, ZrO₂, ZnO, SnO, Al, Ru, Ir, Pt, TiN, TaN, Si₃N₄, WN, NbN.

11. Procédé de dépôt (100) d'un revêtement décoratif et/ou protecteur sur un substrat (10) pour la formation d'un composant horloger (1), selon l'une des revendications précédentes, **caractérisé en ce qu'**une première couche semi-transparente (12) desdites au moins deux couches semi-transparentes (12, 13) de l'empilement (20) présente un indice de réfraction inférieur à 2, préférentiellement inférieur à 1,6, et **en ce qu'**une deuxième couche semi-transparente (13) desdites au moins deux couches semi-transparentes (12, 13) de l'empilement (20) présente un indice de réfraction supérieur à 2, préférentiellement supérieur à 2,5.

12. Composant horloger (1) comportant un substrat (10) et un revêtement présentant une couleur avec un effet interférentiel pour la décoration et/ou la protection dudit article (1), ledit revêtement comportant :
- une première couche (11) opaque recouvrant au moins partiellement au moins une surface du substrat (10) ;
- un empilement (20) d'au moins deux couches semi-transparentes (12, 13) déposées par un procédé ALD (Dépôt par Couches Atomiques) recouvrant ladite première couche (11) ; l'empilement (20) présentant une épaisseur (e₂) fonction de ladite couleur avec un phénomène d'interférence dudit revêtement.

13. Composant horloger (1) selon la revendication 12 **caractérisé en ce que** ladite première couche (11) est une couche métallique ou une couche céramique.

14. Composant horloger (1) selon la revendication 12 **caractérisé en ce que** ladite première couche (11) est une couche de TiN, TiCN, TiCNO, TiC, ZrN, ZrCN, ZrCNO, ZrC, HfN, HfCN, HfCNO, HfC, YN, YC, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN, ou MoCNO.

15. Composant horloger (1) selon l'une des revendications 12 à 14 **caractérisé en ce que** la nature chimique de ladite première couche (11) est fonction du paramètre L* selon le standard CIELAB, conforme aux normes CIE n°15, ISO 7724/1, DIN 5033 Teil 7, ASTM E-1164, de ladite couleur avec un phénomène d'interférence dudit revêtement.

16. Composant horloger (1) selon l'une des revendications 12 à 15 **caractérisé en ce que** la première couche (11) est déposée par un procédé PVD (dépôt physique en phase vapeur).

17. Composant horloger (1) selon l'une des revendications 12 à 16 **caractérisé en ce que** la première couche (11) présente une épaisseur (e₁) supérieure à 450nm, préférentiellement comprise entre 500 nm et 1 µm.

18. Composant horloger (1) selon l'une des revendications 12 à 17 **caractérisé en ce que** lesdites au moins deux couches semi-transparentes (12, 13) de l'empilement (20) sont de natures chimiques différentes et/ou présentent un indice de réfraction différent.

19. Composant horloger (1) selon l'une des revendications 12 à 18 **caractérisé en ce que** les épaisseurs de chacune desdites au moins deux couches semi-transparentes (12, 13) de l'empilement (20) sont fonction des paramètres a* et b*, selon le standard CIELAB, conforme aux normes CIE n°15, ISO 7724/1, DIN 5033 Teil 7, ASTM E-1164, de ladite couleur avec un phénomène d'interférence du revêtement.

20. Composant horloger (1) selon l'une des revendications 12 à 19 **caractérisé en ce que** lesdites au moins deux couches semi-transparentes (12, 13) de l'empilement (20) sont des couches d'un matériau choisi parmi les matériaux diélectriques, semi-conducteurs, métalliques, ou encore céramiques.

21. Composant horloger (1) selon l'une des revendications 12 à 19 **caractérisé en ce que** lesdites au moins deux couches semi-transparentes (12, 13) de l'empilement (20) sont des couches d'un matériau choisi parmi : Al₂O₃, TiO₂, SiO₂, Ta₂O₅, HfO₂, ZrO₂, ZnO, SnO, Al, Ru, Ir, Pt, TiN, TaN, Si₃N₄, WN, NbN.

22. Composant horloger (1) selon l'une des revendications 12 à 21 **caractérisé en ce qu'**une première couche semi-transparente (12) desdites au moins deux couches semi-transparentes (12, 13) de l'empilement (20) présente un indice de réfraction inférieur à 2, préférentiellement inférieur à 1,6, et **en ce qu'**une deuxième couche semi-transparente (13) desdites au moins deux couches semi-transparentes (12, 13) de l'empilement (20) présente un indice de réfraction supérieur à 2, préférentiellement supérieur à 2,5.

23. Composant horloger (1) selon l'une des revendications 12 à 22 **caractérisé en ce que** ledit empilement (20) d'au moins deux couches semi-transparentes (12, 13) déposées par un procédé ALD (dépôt par couches atomiques) présente une épaisseur (e₂) comprise entre 50 nm et 200 nm.

24. Composant horloger (1) selon l'une des revendications 12 à 23 **caractérisé en ce que** ladite première couche (11) opaque du revêtement est une couche de Crc présentant une épaisseur (e1) égale à 500 nm, et **en ce que** ledit empilement (20) est constitué par une deuxième couche semi-transparente (12) de TiO₂ présentant une épaisseur de 34,8 nm et par une troisième couche semi-transparente (13) d'Al₂O₃ présentant une épaisseur de 39,3 nm.

25. Composant horloger (1) selon l'une des revendications 12 à 23 **caractérisé en ce que** ladite première couche (11) opaque du revêtement est une couche de Crc présentant une épaisseur (e1) égale à 500 nm, et **en ce que** ledit empilement (20) est constitué par une deuxième couche semi-transparente (12) de TiO₂ présentant une épaisseur de 41,0 nm et par une troisième couche semi-transparente (13) d'Al₂O₃ présentant une épaisseur de 25,0 nm.

26. Composant horloger (1) selon l'une des revendications 12 à 23 **caractérisé en ce que** ladite première couche (11) opaque du revêtement est une couche de Crc présentant une épaisseur (e1) égale à 500 nm, et **en ce que** ledit empilement (20) est constitué par une deuxième couche semi-transparente (12) d'Al₂O₃ présentant une épaisseur de 10 nm et par une troisième couche semi-transparente (13) de TiO₂ présentant une épaisseur de 55 nm.

27. Pièce d'horlogerie (200) comportant un composant horloger selon l'une des revendications 12 à 26.

## Patentansprüche

1. Verfahren zum Aufbringen (100) einer Verzierungs- und/oder Schutzbeschichtung auf einem Substrat (10) zum Bilden einer Uhrenkomponente (1), das es ermöglicht, das Substrat (10) zu färben, wobei das Aufbringungsverfahren (100) Folgendes umfasst einen ersten Schritt (110) des Aufbringens einer ersten opaken Schicht (11) auf dem Substrat (10); wobei das Verfahren **dadurch gekennzeichnet ist, dass** es Folgendes umfasst einen zweiten Schritt (120) des Aufbringens eines Stapels (20) aus mindestens zwei halbtransparenten Schichten (12, 13), die die erste Schicht (11) bedecken, durch ein ALD-Verfahren (Atomlagenabscheidungsverfahren), wobei die Dicke (e2) des Stapels (20) ausgewählt wird, um eine Farbe mit einer Interferenzerscheinung zu erhalten.

2. Verfahren zum Aufbringen (100) einer Verzierungs- und/oder Schutzbeschichtung auf einem Substrat (10) zum Bilden einer Uhrenkomponente (1) nach dem vorhergehenden Anspruch, **dadurch gekennzeichnet, dass** der erste Schritt (110) ein Schritt des Aufbringens einer ersten Metall- oder Keramikschicht (11) auf dem Substrat (10) ist.

3. Verfahren zum Aufbringen (100) einer Verzierungs- und/oder Schutzbeschichtung auf einem Substrat (10) zum Bilden einer Uhrenkomponente (1) nach dem vorhergehenden Anspruch, **dadurch gekennzeichnet, dass** die erste Schicht (11) eine Schicht aus TiN, TiCN, TiCNO, TiC, ZrN, ZrCN, ZrCNO, ZrC, HfN, HfCN, HfCNO, HfC, YN, YC, YCN, YCNO, TaN, TaC, TaCN, TaCNO, AlN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN oder MoCNO ist.

4. Verfahren zum Aufbringen (100) einer Verzierungs- und/oder Schutzbeschichtung auf einem Substrat (10) zum Bilden einer Uhrenkomponente (1) nach dem vorhergehenden Anspruch, **dadurch gekennzeichnet, dass** die chemische Beschaffenheit der ersten Schicht (11) in Abhängigkeit vom Parameter L* gemäß der CIELAB-Norm, die den Normen CIE Nr. 15, ISO 7724/1, DIN 5033 Teil 7 und ASTM E-1164 entspricht, der Farbe mit einer Interferenzerscheinung der Beschichtung ausgewählt wird.

5. Verfahren zum Aufbringen (100) einer Verzierungs- und/oder Schutzbeschichtung auf einem Substrat (10) zum Bilden einer Uhrenkomponente (1) nach einem der vorhergehenden Ansprüche, **dadurch gekennzeichnet, dass** der erste Schritt (110) durch ein physikalisches PVD-Verfahren (Gasphasenabscheidungsverfahren) durchgeführt wird.

6. Verfahren zum Aufbringen (100) einer Verzierungs- und/oder Schutzbeschichtung auf einem Substrat (10) zum Bilden einer Uhrenkomponente (1) nach einem der vorhergehenden Ansprüche, **dadurch gekennzeichnet, dass** die im ersten Schritt (110) aufgebrachte erste Schicht (11) eine Dicke (e₁) von mehr als 450 nm, vorzugsweise zwischen 500 nm und 1 µm, aufweist.

7. Verfahren zum Aufbringen (100) einer Verzierungs- und/oder Schutzbeschichtung auf einem Substrat (10) zum Bilden einer Uhrenkomponente (1) nach einem der vorhergehenden Ansprüche, **dadurch gekennzeichnet, dass** die mindestens zwei halbtransparenten Schichten (12, 13) des Stapels (20) von unterschiedlicher chemischer Beschaffenheit sind und/oder einen unterschiedlichen Brechungsindex aufweisen.

8. Verfahren zum Aufbringen (100) einer Verzierungs- und/oder Schutzbeschichtung auf einem Substrat (10) zum Bilden einer Uhrenkomponente (1) nach einem der vorhergehenden Ansprüche, **dadurch gekennzeichnet, dass** die Dicken jeder der mindestens zwei halbtransparenten Schichten (12, 13) des Stapels (20) in Abhängigkeit von den Parametern a* und b* gemäß der CIELAB-Norm, die den Normen CIE Nr. 15, ISO 7724/1, DIN 5033 Teil 7 und ASTM E-1164 entspricht, der Farbe mit einer Interferenzerscheinung der Beschichtung ausgewählt werden.

9. Verfahren zum Aufbringen (100) einer Verzierungs- und/oder Schutzbeschichtung auf einem Substrat (10) zum Bilden einer Uhrenkomponente (1) nach einem der vorhergehenden Ansprüche, **dadurch gekennzeichnet, dass** die im zweiten Schritt (120) aufgebrachten mindestens zwei halbtransparenten Schichten (12, 13) des Stapels (20) Schichten aus einem Material sind, das aus den dielektrischen, halbleitenden, metallischen sowie keramischen Materialien ausgewählt wird.

10. Verfahren zum Aufbringen (100) einer Verzierungs- und/oder Schutzbeschichtung auf einem Substrat (10) zum Bilden einer Uhrenkomponente (1) nach einem der vorhergehenden Ansprüche, **dadurch gekennzeichnet, dass** die im zweiten Schritt (120) aufgebrachten mindestens zwei halbtransparenten Schichten (12, 13) des Stapels (20) Schichten aus einem Material sind, das aus Folgendem ausgewählt wird: Al₂O₃, TiO₂, SiO₂, Ta₂O₅, HfO₂, ZrO₂, ZnO, SnO, Al, Ru, Ir, Pt, TiN, TaN, Si₃N₄, WN, NbN.

11. Verfahren zum Aufbringen (100) einer Verzierungs- und/oder Schutzbeschichtung auf einem Substrat (10) zum Bilden einer Uhrenkomponente (1) nach einem der vorhergehenden Ansprüche, **dadurch gekennzeichnet, dass** eine erste halbtransparente Schicht (12) der mindestens zwei halbtransparenten Schichten (12, 13) des Stapels (20) einen Brechungsindex von weniger als 2, vorzugsweise weniger als 1,6, aufweist und dass eine zweite halbtransparente Schicht (13) der mindestens zwei halbtransparenten Schichten (12, 13) des Stapels (20) einen Brechungsindex von mehr als 2, vorzugsweise mehr als 2,5, aufweist.

12. Uhrenkomponente (1), die ein Substrat (10) und eine Beschichtung umfasst, die eine Farbe mit einem Interferenzeffekt für die Verzierung und/oder den Schutz des Gegenstands (1) aufweist, wobei die Beschichtung Folgendes umfasst:
- eine erste opake Schicht (11), die mindestens teilweise mindestens eine Oberfläche des Substrats (10) bedeckt;
- einen Stapel (20) aus mindestens zwei halbtransparenten Schichten (12, 13), die durch ein ALD-Verfahren (Atomlagenabscheidungsverfahren) aufgebracht werden und die erste Schicht (11) bedecken; wobei der Stapel (20) eine Dicke (e₂) in Abhängigkeit von der Farbe mit einer Interferenzerscheinung der Beschichtung aufweist.

13. Uhrenkomponente (1) nach Anspruch 12, **dadurch gekennzeichnet, dass** die erste Schicht (11) eine Metallschicht oder eine Keramikschicht ist.

14. Uhrenkomponente (1) nach Anspruch 12, **dadurch gekennzeichnet, dass** die erste Schicht (11) eine Schicht aus TiN, TiCN, TiCNO, TiC, ZrN, ZrCN, ZrCNO, ZrC, HfN, HfCN, HfCNO, HfC, YN, YC, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN oder MoCNO ist.

15. Uhrenkomponente (1) nach einem der Ansprüche 12 bis 14, **dadurch gekennzeichnet, dass** die chemische Beschaffenheit der ersten Schicht (11) vom Parameter L* gemäß der CIELAB-Norm, die den Normen CIE Nr. 15, ISO 7724/1, DIN 5033 Teil 7 und ASTM E-1164 entspricht, der Farbe mit einer Interferenzerscheinung der Beschichtung abhängt.

16. Uhrenkomponente (1) nach einem der Ansprüche 12 bis 15, **dadurch gekennzeichnet, dass** die erste Schicht (11) durch ein physikalisches PVD-Verfahren (Gasphasenabscheidungsverfahren) aufgebracht wird.

17. Uhrenkomponente (1) nach einem der Ansprüche 12 bis 16, **dadurch gekennzeichnet, dass** die erste Schicht (11) eine Dicke (e₁) von mehr als 450 nm, vorzugsweise zwischen 500 nm und 1 µm, aufweist.

18. Uhrenkomponente (1) nach einem der Ansprüche 12 bis 17, **dadurch gekennzeichnet, dass** die mindestens zwei halbtransparenten Schichten (12, 13) des Stapels (20) von unterschiedlicher chemischer Beschaffenheit sind und/oder einen unterschiedlichen Brechungsindex aufweisen.

19. Uhrenkomponente (1) nach einem der Ansprüche 12 bis 18, **dadurch gekennzeichnet, dass** die Dicken jeder der mindestens zwei halbtransparenten Schichten (12, 13) des Stapels (20) von den Parametern a* und b* gemäß der CIELAB-Norm, die den Normen CIE Nr. 15, ISO 7724/1, DIN 5033 Teil 7 und ASTM E-1164 entspricht, der Farbe mit einer Interferenzerscheinung der Beschichtung abhängen.

20. Uhrenkomponente (1) nach einem der Ansprüche 12 bis 19, **dadurch gekennzeichnet, dass** die mindestens zwei halbtransparenten Schichten (12, 13) des Stapels (20) Schichten aus einem Material sind, das aus den dielektrischen, halbleitenden, metallischen sowie keramischen Materialien ausgewählt wird.

21. Uhrenkomponente (1) nach einem der Ansprüche 12 bis 19, **dadurch gekennzeichnet, dass** die mindestens zwei halbtransparenten Schichten (12, 13) des Stapels (20) Schichten aus einem Material sind, das aus Folgendem ausgewählt wird: Al₂O₃, TiO₂, SiO₂, Ta₂O₅, HfO₂, ZrO₂, ZnO, SnO, Al, Ru, Ir, Pt, TiN, TaN, Si₃N₄, WN, NbN.

22. Uhrenkomponente (1) nach einem der Ansprüche 12 bis 21, **dadurch gekennzeichnet, dass** eine erste halbtransparente Schicht (12) der mindestens zwei halbtransparenten Schichten (12, 13) des Stapels (20) einen Brechungsindex von weniger als 2, vorzugsweise weniger als 1,6, aufweist und dass eine zweite halbtransparente Schicht (13) der mindestens zwei halbtransparenten Schichten (12, 13) des Stapels (20) einen Brechungsindex von mehr als 2, vorzugsweise mehr als 2,5, aufweist.

23. Uhrenkomponente (1) nach einem der Ansprüche 12 bis 22, **dadurch gekennzeichnet, dass** der Stapel (20) aus mindestens zwei halbtransparenten Schichten (12, 13), die durch ein ALD-Verfahren (Atomlagenabscheidungsverfahren) aufgebracht werden, eine Dicke (e2) zwischen 50 nm und 200 nm aufweist.

24. Uhrenkomponente (1) nach einem der Ansprüche 12 bis 23, **dadurch gekennzeichnet, dass** die erste opake Schicht (11) der Beschichtung eine Schicht aus Crc ist, die eine Dicke (e1) von 500 nm aufweist, und dass der Stapel (20) aus einer zweiten halbtransparenten Schicht (12) aus TiO₂, die eine Dicke von 34,8 nm aufweist, und aus einer dritten halbtransparenten Schicht (13) aus Al₂O₃, die eine Dicke von 39,3 nm aufweist, besteht.

25. Uhrenkomponente (1) nach einem der Ansprüche 12 bis 23, **dadurch gekennzeichnet, dass** die erste opake Schicht (11) der Beschichtung eine Schicht aus Crc ist, die eine Dicke (e1) von 500 nm aufweist, und dass der Stapel (20) aus einer zweiten halbtransparenten Schicht (12) aus TiO₂, die eine Dicke von 41,0 nm aufweist, und aus einer dritten halbtransparenten Schicht (13) aus Al₂O₃, die eine Dicke von 25,0 nm aufweist, besteht.

26. Uhrenkomponente (1) nach einem der Ansprüche 12 bis 23, **dadurch gekennzeichnet, dass** die erste opake Schicht (11) der Beschichtung eine Schicht aus Crc ist, die eine Dicke (e1) von 500 nm aufweist, und dass der Stapel (20) aus einer zweiten halbtransparenten Schicht (12) aus Al₂O₃, die eine Dicke von 10 nm aufweist, und aus einer dritten halbtransparenten Schicht (13) aus TiO₂, die eine Dicke von 55 nm aufweist, besteht.

27. Uhr (200), die eine Uhrenkomponente nach einem der Ansprüche 12 bis 26 umfasst.

## Claims

1. Method for depositing (100) a decorative and/or protective coating on a substrate (10) for the formation of a clockwork component (1), making it possible to colour said substrate (10), said deposition method (100) comprising a first step (110) of depositing a first opaque layer (11) on the substrate (10), said method being **characterised in that** it comprises a second step (120) of depositing by an ALD (Atomic Layer Deposition) method a stack (20) of at least two semi-transparent layers (12, 13) covering said first layer (11); the thickness (e2) of the stack (20) being selected in such a way as to obtain a colour with an interference phenomenon.

2. Method for depositing (100) a decorative and/or protective coating on a substrate (10) for the formation of a clockwork component (1), according to the preceding claim **characterised in that** the first step (110) is a step of depositing a first metal or ceramic layer (11) on said substrate (10).

3. Method for depositing (100) a decorative and/or protective coating on a substrate (10) for the formation of a clockwork component (1), according to the preceding claim **characterised in that** said first layer (11) is a layer of TiN, TiCN, TiCNO, TiC, ZrN, ZrCN, ZrCNO, ZrC, HfN, HfCN, HfCNO, HfC, YN, YD, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN, or MoCNO.

4. Method for depositing (100) a decorative and/or protective coating on a substrate (10) for the formation of a clockwork component (1), according to the preceding claim **characterised in that** the chemical nature of said first layer (11) is selected depending on the L* parameter according to the CIELAB standard in accordance with the standards CIE no. 15, ISO 7724/1, DIN 5033 Teil 7, ASTM E-1164 of said colour with an interference phenomenon of said coating.

5. Method for depositing (100) a decorative and/or protective coating on a substrate (10) for the formation of a clockwork component (1), according to one of the preceding claims, **characterised in that** the first step (110) is performed by a PVD (Physical Vapour Deposition) method.

6. Method for depositing (100) a decorative and/or protective coating on a substrate (10) for the formation of a clockwork component (1), according to one of the preceding claims, **characterised in that** the first layer (11) deposited during the first step (110) has a thickness (e₁) greater than 450 nm, preferably between 500 nm and 1 µm.

7. Method for depositing (100) a decorative and/or protective coating on a substrate (10) for the formation of a clockwork component (1), according to one of the preceding claims, **characterised in that** said at least two semi-transparent layers (12, 13) of the stack (20) are of different chemical natures and/or have a different refractive index.

8. Method for depositing (100) a decorative and/or protective coating on a substrate (10) for the formation of a clockwork component (1), according to one of the preceding claims, **characterised in that** the thickness of each of said at least two semi-transparent layers (12, 13) of the stack (20) are selected depending on the a* and b* parameters, according to the CIELAB standard in accordance with the standards CIE no. 15, ISO 7724/1, DIN 5033 Teil 7, ASTM E-1164, of said colour with an interference phenomenon of the coating.

9. Method for depositing (100) a decorative and/or protective coating on a substrate (10) for the formation of a clockwork component (1), according to one of the preceding claims, **characterised in that** said at least two semi-transparent layers (12, 13) of the stack (20) deposited during the second step (120) are layers of a material selected from the dielectric, semi-conductive, metal, or ceramic materials.

10. Method for depositing (100) a decorative and/or protective coating on a substrate (10) for the formation of a clockwork component (1), according to one of the preceding claims, **characterised in that** said at least two semi-transparent layers (12, 13) of the stack (20) deposited during the second step (120) are layers of a material selected from: Al₂O₃, TiO₂, SiO₂, Ta₂O₅, HfO₂, ZrO₂, ZnO, SnO, Al, Ru, Ir, Pt, TiN, TaN, Si₃N₄, WN, NbN.

11. Method for depositing (100) a decorative and/or protective coating on a substrate (10) for the formation of a clockwork component (1), according to one of the preceding claims, **characterised in that** a first semi-transparent layer (12) of said at least two semi-transparent layers (12, 13) of the stack (20) have a refractive index less than 2, preferably less than 1.6, and **in that** a second semi-transparent layer (13) of said at least two semi-transparent layers (12, 13) of the stack (20) has a refractive index greater than 2, preferably greater than 2.5.

12. Clockwork component (1) including a substrate (10) and a coating having a colour with an interference effect for the decoration and/or the protection of said item (1), said coating including:
- a first opaque layer (11) covering at least partially at least one surface of the substrate (10);
- a stack (20) of at least two semi-transparent layers (12, 13) deposited by an ALD (Atomic Layer Deposition) method covering said first layer (11); the stack (20) having a thickness (e₂) depending on said colour with an interference phenomenon of said coating.

13. Clockwork component (1) according to claim 12 **characterised in that** said first layer (11) is a metal layer or a ceramic layer.

14. Clockwork component according to claim 12 **characterised in that** said first layer (11) is a layer of TiN, TiCN, TiCNO, TiC, ZrN, ZrCN, ZrCNO, ZrC, HfN, HfCN, HfCNO, HfC, YN, YD, YCN, YCNO, TaN, TaC, TaCN, TaCNO, AIN, AICN, AICNO, CrN, CrC, CrNO, CrCNO, VN, VC, VCN, VCNO, TiZrN, TiZrCN, TiZrC, TiZrCNO, NbN, NbC, NbCN, NbCNO, WN, WC, WCN, WCNO, MoN, MoC, MoCN, or MoCNO.

15. Clockwork component (1) according to one of claims 12 to 14 **characterised in that** the chemical nature of said first layer (11) depends on the L* parameter according to the CIELAB standard in accordance with the standards CIE no. 15, ISO 7724/1, DIN 5033 Teil 7, ASTM E-1164 of said colour with an interference phenomenon of said coating.

16. Clockwork component according to one of claims 12 to 15 **characterised in that** the first layer (11) is deposited by a PVD (Physical Vapour Deposition) method.

17. Clockwork component (1) according to one of claims 12 to 16 **characterised in that** the first layer (11) has a thickness (e₁) greater than 450 nm, preferably between 500 nm and 1 µm.

18. Clockwork component according to one of claims 12 to 17 **characterised in that** said at least two semi-transparent layers (12, 13) of the stack (20) are of different chemical natures and/or have a different refractive index.

19. Clockwork component (1) according to one of claims 12 to 18 **characterised in that** the thicknesses of each of said at least two semi-transparent layers (12, 13) of the stack (20) depend on the a* and b* parameters, according to the CIELAB standard in accordance with the standards CIE no.15, ISO 7724/1, DIN 5033 Teil 7, ASTM E-1164, of said colour with an interference phenomenon of the coating.

20. Clockwork component (1) according to one of claims 12 to 19 **characterised in that** said at least two semi-transparent layers (12, 13) of the stack (20) are layers of a material selected from the dielectric, semi-conductor, metal or ceramic materials.

21. Clockwork component (1) according to one of claims 12 to 19 **characterised in that** said at least two semi-transparent layers (12, 13) of the stack (20) are layers of a material selected from: Al₂O₃, TiO₂, SiO₂, Ta₂O₅, HfO₂, ZrO₂, ZnO, SnO, Al, Ru, Ir, Pt, TiN, TaN, Si₃N₄, WN, NbN.

22. Clockwork component (1) according to one of claims 12 to 21 **characterised in that** a first semi-transparent layer (12) of said at least two semi-transparent layers (12, 13) of the stack (20) has a refractive index less than 2, preferably less than 1.6, and **in that** a second semi-transparent layer (13) of said at least two semi-transparent layers (12, 13) of the stack (20) has a refractive index greater than 2, preferably greater than 2.5.

23. Clockwork component (1) according to one of claims 12 to 22 **characterised in that** said stack (20) of at least two semi-transparent layers (12, 13) deposited by an ALD (Atomic Layer Deposition) method has a thickness (e₂) between 50 nm and 200 nm.

24. Clockwork component (1) according to one of claims 12 to 23 **characterised in that** said first opaque layer (11) of the coating is a layer of Crc having a thickness (e1) equal to 500 nm, and **in that** said stack (20) consists of a second semi-transparent layer (12) of TiO₂ having a thickness of 34.8 nm and of a third semi-transparent layer (13) of Al₂O₃ having a thickness of 39.3 nm.

25. Clockwork component (1) according to one of claims 12 to 23 **characterised in that** said first opaque layer (11) of the coating is a layer of Crc having a thickness (e1) equal to 500 nm, and **in that** said stack (20) consists of a second semi-transparent layer (12) of TiO₂ having a thickness of 41.0 nm and of a third semi-transparent layer (13) of Al₂O₃ having a thickness of 25.0 nm.

26. Clockwork component (1) according to one of claims 12 to 23 **characterised in that** said first opaque layer (11) of the coating is a layer of Crc having a thickness (e1) equal to 500 nm, and **in that** said stack (20) consists of a second semi-transparent layer (12) of Al₂O₃ having a thickness of 10 nm and of a third semi-transparent layer (13) of TiO₂ having a thickness of 55 nm.

27. Timepiece (200) including a clockwork component according to one of claims 12 to 26.
